# EUROPÄISCHE PATENTANMELDUNG

(11) **EP 3 904 892 A1**
(43) Veröffentlichungstag der Anmeldung: **03.11.2021**
(21) Anmeldenummer: 20172300.4
(22) Anmeldetag: 30.04.2020
(51) Int. Cl.: G01R 19/00, G05F 3/26, H03K 17/082, H03F 3/343, H02H 3/087

(54) **FAHRZEUGSCHALTUNGSANORDNUNG ZUR ÜBERLASTUNGSDETEKTIERENDEN VERSORGUNG EINER ELEKTRISCHEN LAST MIT EINER FAHRZEUGBORDSPANNUNG**

(71) Anmelder: ZKW Group GmbH, 3250 Wieselburg (AT)
(72) Erfinder: Guth, Christian, 7433 Mariasdorf (AT)
(74) Vertreter: Patentanwaltskanzlei Matschnig & Forsthuber OG

(57) **Zusammenfassung**

Die Erfindung betrifft eine Fahrzeugschaltungsanordnung (1) zur überlastungsdetektierenden Versorgung einer elektrischen Last (2) mit einer Fahrzeugbordspannung (UFB), wobei die elektrische Last (2) eine vorgebbare Nennleistung aufweist, umfassend
- einen Fahrzeugbordspannungseingang (E1),
- ein Steuergerät (3) zur Steuerung einer Fahrzeugfunktion, wobei das Steuergerät (3) einen integrierten Halbleiterbaustein (3a), z.B. einem System Basis Chip (SBC), aufweist, wobei der integrierte Halbleiterbaustein einen integrierten High-Side-Switch (S1) der mit dem Fahrzeugbordspannungseingang (E1) zur Durchschaltung einer an dem Fahrzeugbordspannungseingang (E1) anliegenden Fahrzeugbordspannung (UFB) auf einen High-Side-Switch Ausgang (A1) verbunden ist, wobei der High-Side-Switch Ausgang (A1) eine vorgegebene Stromtragfähigkeit aufweist und das Steuergerät (3) dazu eingerichtet ist, den Ausgangsstrom (IA1) des High-Side-Switch-Ausgangs (A1) zu erfassen, wobei eine Nennstromaufnahme der zu versorgenden Nennlast oberhalb der vorgegebenen Stromtragfähigkeit des High-Side-Switch-Ausgangs (A1) liegt

## Beschreibung

Die Erfindung betrifft eine Fahrzeugschaltungsanordnung zur überlastungsdetektierenden Versorgung einer elektrischen Last mit einer Fahrzeugbordspannung, wobei die elektrische Last eine vorgebbare Nennleistung aufweist, umfassend
- einen Fahrzeugbordspannungseingang,
- ein Steuergerät zur Steuerung einer Fahrzeugfunktion, wobei das Steuergerät einen integrierten Halbleiterbaustein, z.B. einem System Basis Chip, aufweist, wobei der integrierte Halbleiterbaustein einen integrierten High-Side-Switch der mit dem Fahrzeugbordspannungseingang zur Durchschaltung einer an dem Fahrzeugbordspannungseingang anliegenden Fahrzeugbordspannung auf einen High-Side-Switch Ausgang verbunden ist, wobei der High-Side-Switch Ausgang eine vorgegebene Stromtragfähigkeit aufweist und das Steuergerät dazu eingerichtet ist, den Ausgangsstrom des High-Side-Switch-Ausgangs zu erfassen, wobei eine Nennstromaufnahme der zu versorgenden Nennlast oberhalb der vorgegebenen Stromtragfähigkeit des High-Side-Switch-Ausgangs liegt.

Solche Fahrzeugschaltungsanordnungen sind aus dem Stand der Technik bekannt geworden. Ein Problem von integrierten High-Side-Switches bei der Versorgung von elektrischen Lasten liegt in der niedrigen Ausgangsleistung begründet. Lasten, die höhere Ausgangsleistungen benötigen, erfordern daher üblicherweise teurere zusätzliche Komponenten, mit denen eine leistungsstarke Versorgung der externen Lasten sichergestellt werden kann.

Eine Aufgabe der Erfindung besteht daher darin eine Fahrzeugschaltungsanordnung zu schaffen, die eine kostengünstige Möglichkeit bietet, leistungsintensivere externe Lasten versorgen zu können.

Diese Aufgabe wird mit einer Fahrzeugschaltungsanordnung der eingangs genannten Art gelöst, bei welcher erfindungsgemäß vorgesehen ist, dass die Fahrzeugschaltungsanordnung weiters
- eine Widlar-Stromspiegelschaltung in PNP-Konfiguration aufweist,
   wobei der Emitter eines ersten Transistors einer ersten Spiegelhälfte der Widlar-Stromspiegelschaltung über einen in Serie geschalteten ohmschen Skalierungswiderstand mit dem Ausgang des High-Side-Switches verbunden ist, der Kollektor des ersten Transistors gegen Masse verbunden ist und die Basis des ersten Transistors mit der Basis eines zweiten Transistors verbunden ist, wobei der zweite Transistor Teil einer zweiten Spiegelhälfte ist, und der zweite Transistor emitterseitig mit dem Fahrzeugbordspannungseingang und kollektorseitig mit einer zu versorgenden und zu überwachenden elektrischen Last verbunden ist, wobei die elektrische Last gegen Masse geschaltet ist, wobei der Skalierungswiderstand so gewählt ist, dass

- der lastseitig aufgenommene Strom dergestalt mit einem Übersetzungsverhältnis auf die erste Spiegelhälfte der Widlar-Stromspiegelschaltung auf den Ausgangsstrom des High-Side-Switches gespiegelt wird, dass ein lastseitiger Nennstrom einen Wert des High-Side-Switch-seitigen Ausgangsstromes verursacht, der unterhalb der Stromtragfähigkeit des High-Side-Switch-Ausgangs liegt und ein Überschreiten des lastseitigen Nennstromes um einen vorgebbaren Grenzwert zu einem Überschreiten der Stromtragfähigkeit des High-Side-Switch-Ausgangs führt und somit eine Überlastung durch das Steuergerät anhand des Überschreitens der Stromtragfähigkeit des High-Side-Switch-Ausgangs detektiert wird.

Durch Einsatz dieser Merkmale ist es möglich, einen High-Side-Switch mit geringer Ausgangsleistung dennoch in die Versorgung einer Last einzubinden, die eine Nennleistung verbraucht, die deutlich oberhalb der Ausgangsleistung des High-Side-Switches liegt. Durch die Stromspiegelung wird der seitens der Last aufgenommene Strom entsprechend dem eingestellten Übersetzungsverhältnis auf den High-Side-Switch-Ausgang gespiegelt, sodass der vom Switch abgegebene Ausgangsstrom mit dem Laststrom korreliert. Sollte die Last aufgrund eines Lastfehlers einen Überstrom oder einen Kurzschlussstrom aufnehmen, so führt dies zu einem Überschreiten der Stromtragfähigkeit des Ausgangs des High-Side-Switches und somit zu einer Erkennung des Fehlers durch das Steuergerät. Basierend darauf können Maßnahmen zur Behebung des Fehlers eingeleitet werden. Der Fehler kann durch Setzen eines Flags automatisch signalisiert werden. Gegebenenfalls kann die Last auch automatisiert abgeschaltet werden.

Bei dem Steuergerät kann es sich um ein herkömmliches Steuergerät handeln, das ohnehin in einem Fahrzeug vorhanden ist, z.B. um eine Fahrzeugfunktion zu steuern. Dabei kann es sich beispielsweise um die Funktion von einem Fahrzeugscheinwerfer und/oder auch um eine einfache Lüfterfunktion handeln. Die Fahrzeugbordspannung beträgt derzeit bei PKWs üblicherweise 12V Nennspannung, bei LKWs beträgt diese Spannung hingegen normalerweise 24V. Grundsätzlich kann die Fahrzeugbordspannung frei gewählt werden - die eingesetzten Komponenten werden dann lediglich entsprechend den zu erwartenden Spannungen ausgelegt. Gleiches gilt für die zu erwartenden Leistungen. Die Fahrzeugschaltungsanordnung kann zur Versorgung von Lasten bestimmter Nennleistung optimiert werden. Dementsprechend können dann die einzelnen Werte, insbesondere das Übersetzungsverhältnis der Stromspiegelschaltung, durch den Fachmann für die jeweilige Anwendung optimiert werden.

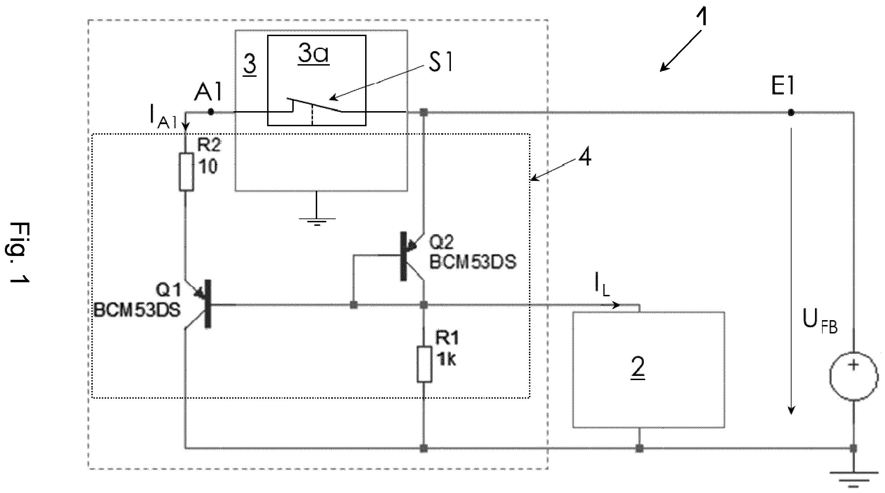

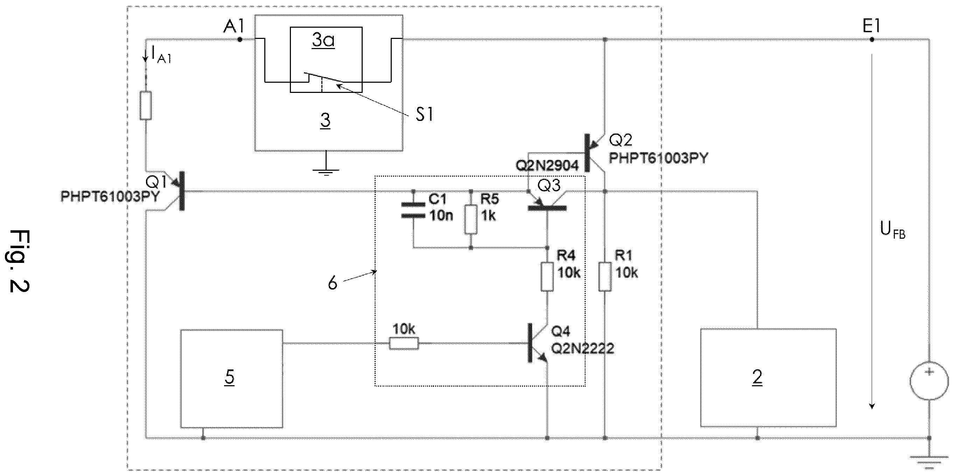

Weiters kann vorgesehen sein, dass die Fahrzeugschaltungsanordnung einen automatisierten Überlastungsschutz umfasst, indem das Steuergerät mit einem Mikrokontroller verbunden ist, dem der Wert des am High-Side-Switch-Ausgang erfassten Stromes zugeführt ist, wobei der Mikrokontroller dergestalt zur Ansteuerung einer Abschaltvorrichtung eingerichtet ist, dass die Last im Falle des Überschreitens der Stromtragfähigkeit des High-Side-Switch-Ausgangs automatisch abgeschaltet wird. Im Detail kann dabei vorgesehen sein, dass die Abschaltvorrichtung mit der Basis des lastversorgenden Transistors verbunden ist und zur Abschaltung die Basis-Emitter-Spannung dieses Transistors absenkt und damit den Transistor abschaltet. Eine solche Anordnung ist in Figur 2 gezeigt. Findet z.B. ein Kurzschluss an einem versorgten Lüfter statt, erhöht sich der Strom durch Q2 (siehe Fig. 1 und 2), wodurch über die Spiegelung der Strom an Q1 ansteigt. Dieser Anstieg wird am Ausgang A1 des High-Side-Switches erfasst und es kann ein Flag gesetzt werden, das vom Mikrokontroller laufend abgefragt wird, sodass der Mikrokontroller bei Feststellen des gesetzten Flags die besagte Maßnahme zur Abschaltung von Q2 einleiten kann.

Weiters kann vorgesehen sein, dass das Spiegelverhältnis der Widlar-Stromspiegelschaltung dergestalt gewählt ist, dass der lastseitige Strom der zweiten Stromspiegelhälfte in einem Verhältnis von zumindest 10:1 auf die erste Stromspiegelhälfte gespiegelt wird. Mit Blick auf Fig. 1 bedeutet dies, dass der Strom I_{A1} maximal 1/10 des Wertes von I_{L} beträgt.

Insbesondere kann vorgesehen sein, dass das Übersetzungsverhältnis der Stromspiegelschaltung dergestalt gewählt ist, dass eine Nennstrom-Aufnahme der Last zu einem Ausgangsstrom des High-Side-Switch-Ausgangs führt, der zumindest 50% unterhalb der maximalen Stromtragfähigkeit des High-Side-Switch-Ausganges liegt. Das Verhältnis kann beispielsweise in einem Bereich von 1:10 bis 1:20 liegen. Das bedeutet in diesem Fall, dass die lastseitige Stromaufnahme den Nennstrom um zumindest den doppelten Wert überschreiten muss, um eine Überlastung des High-Side-Switch-Ausgangs auszulösen. Damit können Leistungsreserven geschaffen werden, die z.B. für zulässige Betriebszustände erforderlich sind, die zwischenzeitlich einen über Nennstrom hinaus erhöhten Strombedarf aufweisen - wie z.B. bei dem Anlaufen eines Lüfters. Somit können reguläre Stromspitzen berücksichtigt werden. Die Auswahl des Übersetzungsverhältnisses kann in Abhängigkeit von der zu versorgenden Last optimal eingestellt werden. Alternativ zu dem vorgeschlagenen Verhältnis können auch noch größere Abstände gewählt werden, z.B. kann als Grenze der dreifache, vierfache oder sogar zehnfache Nennstrom vorgesehen sein.

Weiters kann vorgesehen sein, dass die Stromtragfähigkeit des High-Side-Switch-Ausganges maximal 100 mA beträgt.

Insbesondere kann vorgesehen sein, dass die Fahrzeugschaltungsanordnung die zu versorgende Last umfasst, wobei diese Last einen Lüfter aufweist.

Weiters kann vorgesehen sein, dass die Fahrzeugschaltungsanordnung die zu versorgende Last umfasst, wobei diese Last ein Lichtmodul, insbesondere ein LED-Lichtmodul, aufweist.

Insbesondere kann vorgesehen sein, dass der High-Side-Switch als Teil eines System-Basis-Chips ausgebildet ist.

Weiters betrifft die Erfindung ein elektrisches Fahrzeugsystem umfassend eine erfindungsgemäße Fahrzeugschaltungsanordnung und eine Fahrzeugbatterie zur Ausgabe der Fahrzeugbordspannung, wobei die Fahrzeugbatterie mit dem Fahrzeugbordspannungseingang der Fahrzeugschaltungsanordnung elektrisch verbunden ist.

Ebenso betrifft die Erfindung einen Fahrzeugscheinwerfer, umfassend eine erfindungsgemäße Fahrzeugschaltungsanordnung. Weiters betrifft die Erfindung ein Fahrzeug, umfassend eine erfindungsgemäße Fahrzeugschaltungsanordnung und/oder ein erfindungsgemäßes Fahrzeugsystem und/oder einen erfindungsgemäßen Fahrzeugscheinwerfer.

Die Erfindung ist im Folgenden anhand von beispielhaften und nicht einschränkenden Ausführungsformen näher erläutert, die in den Figuren veranschaulicht ist. Darin zeigen
Figur 1 eine schematische Darstellung einer ersten Ausführungsform der Erfindung, und
Figur 2 eine schematische Darstellung einer Weiterbildung der ersten Ausführungsform.

In den folgenden Figuren bezeichnen - sofern nicht anders angegeben - gleiche Bezugszeichen gleiche Merkmale.

Figur 1 zeigt eine schematische Darstellung einer ersten Ausführungsform der Fahrzeugschaltungsanordnung 1 zur überlastungsdetektierenden Versorgung einer elektrischen Last 2 mit einer Fahrzeugbordspannung U_{FB}, wobei die elektrische Last 2 eine vorgebbare Nennleistung aufweist. Die Fahrzeugschaltungsanordnung 1 umfasst einen Fahrzeugbordspannungseingang E1, ein Steuergerät 3 zur Steuerung einer Fahrzeugfunktion, wobei das Steuergerät 3 einen integrierten Halbleiterbaustein 3a, z.B. einem System Basis Chip SBC, aufweist, wobei der integrierte Halbleiterbaustein 3a einen integrierten High-Side-Switch S1 aufweist. Der Switch S1 ist mit dem Fahrzeugbordspannungseingang E1 zur Durchschaltung einer an dem Fahrzeugbordspannungseingang E1 anliegenden Fahrzeugbordspannung U_{FB} auf einen High-Side-Switch Ausgang A1 eingerichtet. Dabei weist der High-Side-Switch Ausgang A1 eine vorgegebene Stromtragfähigkeit auf. Das Steuergerät 3 ist dazu eingerichtet, den Ausgangsstrom I_{A1} des High-Side-Switch-Ausgangs A1 zu erfassen, wobei die Last 2 bzw. die Stromtragfähigkeit so gewählt ist, dass eine Nennstromaufnahme der zu versorgenden Last 2 oberhalb der vorgegebenen Stromtragfähigkeit des High-Side-Switch-Ausgangs A1 liegt.

Die Fahrzeugschaltungsanordnung 1 weist weiters eine Widlar-Stromspiegelschaltung 4 in PNP-Konfiguration auf. Die Widlar-Stromspiegelschaltung 4 ist in Fig. 1 zur besseren Darstellung durch ein fein punktiertes Rechteck umschlossen. Der Emitter des ersten Transistors Q1 einer ersten Spiegelhälfte der Widlar-Stromspiegelschaltung ist über einen in Serie geschalteten ohmschen Skalierungswiderstand R2 mit dem Ausgang A1 des High-Side-Switches S1 verbunden. Der Kollektor des ersten Transistors Q1 ist gegen Masse und die Basis des ersten Transistors Q1 ist mit der Basis eines zweiten Transistors Q2 verbunden. Dieser zweite Transistor Q2 ist Teil einer zweiten Spiegelhälfte. Der zweite Transistor Q2 ist emitterseitig mit dem Fahrzeugbordspannungseingang E1 und kollektorseitig mit einer zu versorgenden und zu überwachenden elektrischen Last 2 verbunden ist, wobei die elektrische Last 2 gegen Masse geschaltet ist. Der Skalierungswiderstand R2 ist dabei so gewählt ist, dass der lastseitig aufgenommene Strom IL dergestalt mit einem Übersetzungsverhältnis auf die erste Spiegelhälfte der Widlar-Stromspiegelschaltung auf den Ausgangsstrom I_{A1} des High-Side-Switches S1 gespiegelt wird, dass ein lastseitiger Nennstrom I_{LN} (nicht in den Figuren dargestellt, sondern z.B. dem Datenblatt der jeweiligen Last 2 zu entnehmen) einen Wert des High-Side-Switch-seitigen Ausgangsstromes I_{A1} verursacht, der unterhalb der Stromtragfähigkeit des High-Side-Switch-Ausgangs A1 liegt und ein Überschreiten des lastseitigen Nennstromes I_{LN} um einen vorgebbaren Grenzwert zu einem Überschreiten der Stromtragfähigkeit des High-Side-Switch-Ausgangs A1 führt und somit eine Überlastung durch das Steuergerät 3 anhand des Überschreitens der Stromtragfähigkeit des High-Side-Switch-Ausgangs A1 detektiert wird. Die Spiegelung erfolgt dabei auf effektive Weise, indem bei Durchschalten des Switches S1 die Basisemitterspannung an Q1 im Vergleich zu der Basisemitterspannung von Q2 um den Spannungsabfall an R2 reduziert ist. Dieser Spannungsabfall resultiert aus dem Produkt aus Strom I_{A1} und Widerstand R2. Er ist somit proportional zu R2, wodurch durch geeignete Wahl von R2 das Übersetzungsverhältnis der Stromspiegelschaltung gezielt eingestellt werden kann. Es kann vorteilhaft sein, wenn die beiden Transistoren Q1 und Q2 zueinander identisch sind. Auf diese Weise kann sichergestellt werden, dass sowohl der Verstärkungsfaktor der Transistoren als auch interne Bahnwiderstände einander weitgehend gleichen, wodurch eine besonders genaue und sensible Spiegelung erreicht werden kann. Der Widerstand R1 dient übrigens in der vorliegenden Schaltung nur als Hilfswiderstand und könnte auch weggelassen werden.

Figur 2 zeigt eine schematische Darstellung einer Weiterbildung der ersten Ausführungsform. Darin ist ein automatisierter Überlastungsschutz integriert, indem das Steuergerät 3 mit einem Mikrokontroller 5 verbunden ist, dem der Wert des am High-Side-Switch-Ausgang A1 erfassten Stromes I_{A1} zugeführt ist. Der Mikrokontroller 5 ist dergestalt zur Ansteuerung einer Abschaltvorrichtung 6 eingerichtet, dass die Last 2 im Falle des Überschreitens der Stromtragfähigkeit des High-Side-Switch-Ausgangs A1 automatisch abgeschaltet wird. Im Detail kann der durch den Mikrokontroller angesteuerter Transistor Q3 ein Fließen des Basisstromes durch den Transistor Q2 verhindern, wodurch Q2 sperrt. Q3 kann durchgeschaltet werden, sobald Q4 durch zB. einen Mikrokontroller-GPIO Pin ebenfalls durchgeschaltet wird. Über den Spannungsteiler R1 und R4 stellt sich an der BE-Strecke von Q3 eine Spannung ein, die zum Durchschalten führt. C1 dient der Dämpfung um ein langsames Ansteigen von Ausgangs- und Messstrom zu erreichen.

Die Erfindung ist nicht auf die gezeigten Ausführungsformen beschränkt, sondern durch den gesamten Schutzumfang der Ansprüche definiert. Auch können einzelne Aspekte der Erfindung bzw. der Ausführungsformen aufgegriffen und miteinander kombiniert werden. Etwaige Bezugszeichen in den Ansprüchen sind beispielhaft und dienen nur der einfacheren Lesbarkeit der Ansprüche, ohne diese einzuschränken.

## Patentansprüche

1. Fahrzeugschaltungsanordnung (1) zur überlastungsdetektierenden Versorgung einer elektrischen Last (2) mit einer Fahrzeugbordspannung (UFB), wobei die elektrische Last (2) eine vorgebbare Nennleistung aufweist, umfassend
- einen Fahrzeugbordspannungseingang (E1),
- ein Steuergerät (3) zur Steuerung einer Fahrzeugfunktion, wobei das Steuergerät (3) einen integrierten Halbleiterbaustein (3a), z.B. einem System Basis Chip (SBC), aufweist, wobei der integrierte Halbleiterbaustein einen integrierten High-Side-Switch (S1) aufweist, der mit dem Fahrzeugbordspannungseingang (E1) zur Durchschaltung einer an dem Fahrzeugbordspannungseingang (E1) anliegenden Fahrzeugbordspannung (UFB) auf einen High-Side-Switch Ausgang (A1) verbunden ist, wobei der High-Side-Switch Ausgang (A1) eine vorgegebene Stromtragfähigkeit aufweist und das Steuergerät (3) dazu eingerichtet ist, den Ausgangsstrom (IA1) des High-Side-Switch-Ausgangs (A1) zu erfassen, wobei eine Nennstromaufnahme der zu versorgenden Nennlast oberhalb der vorgegebenen Stromtragfähigkeit des High-Side-Switch-Ausgangs (A1) liegt,
**dadurch gekennzeichnet, dass** die Fahrzeugschaltungsanordnung weiters
- eine Widlar-Stromspiegelschaltung (4) in PNP-Konfiguration aufweist,
wobei der Emitter eines ersten Transistors (Q1) einer ersten Spiegelhälfte der Widlar-Stromspiegelschaltung über einen in Serie geschalteten ohmschen Skalierungswiderstand (R2) mit dem Ausgang (A1) des High-Side-Switches (S1) verbunden ist, der Kollektor des ersten Transistors (Q1) gegen Masse verbunden ist und die Basis des ersten Transistors (Q1) mit der Basis eines zweiten Transistors (Q2) verbunden ist, wobei der zweite Transistor (Q2) Teil einer zweiten Spiegelhälfte ist, und der zweite Transistor (Q2) emitterseitig mit dem Fahrzeugbordspannungseingang (E1) und kollektorseitig mit einer zu versorgenden und zu überwachenden elektrischen Last (2) verbunden ist, wobei die elektrische Last (2) gegen Masse geschaltet ist, wobei der Skalierungswiderstand (R2) so gewählt ist, dass
• der lastseitig aufgenommene Strom (IL) dergestalt mit einem Übersetzungsverhältnis auf die erste Spiegelhälfte der Widlar-Stromspiegelschaltung auf den Ausgangsstrom (IA1) des High-Side-Switches (S1) gespiegelt wird, dass ein lastseitiger Nennstrom (ILN) einen Wert des High-Side-Switch-seitigen Ausgangsstromes (IA1) verursacht, der unterhalb der Stromtragfähigkeit des High-Side-Switch-Ausgangs (A1) liegt und ein Überschreiten des lastseitigen Nennstromes (ILN) um einen vorgebbaren Grenzwert zu einem Überschreiten der Stromtragfähigkeit des High-Side-Switch-Ausgangs (A1) führt und somit eine Überlastung durch das Steuergerät (3) anhand des Überschreitens der Stromtragfähigkeit des High-Side-Switch-Ausgangs (A1) detektiert wird.

2. Fahrzeugschaltungsanordnung (1) nach Anspruch 1 umfassend einen automatisierten Überlastungsschutz, indem das Steuergerät (3) mit einem Mikrokontroller (5) verbunden ist, dem der Wert des am High-Side-Switch-Ausgang (A1) erfassten Stromes (IA1) zugeführt ist, wobei der Mikrokontroller (5) dergestalt zur Ansteuerung einer Abschaltvorrichtung (6) eingerichtet ist, dass die Last (2) im Falle des Überschreitens der Stromtragfähigkeit des High-Side-Switch-Ausgangs (A1) automatisch abgeschaltet wird.

3. Fahrzeugschaltungsanordnung (1) nach Anspruch 1 oder 2, wobei das Spiegelverhältnis der Widlar-Stromspiegelschaltung (4) dergestalt gewählt ist, dass der lastseitige Strom (IL) der zweiten Stromspiegelhälfte in einem Verhältnis von zumindest 10:1 auf die erste Stromspiegelhälfte gespiegelt wird.

4. Fahrzeugschaltungsanordnung (1) nach einem der vorhergehenden Ansprüche, wobei das Übersetzungsverhältnis der Stromspiegelschaltung dergestalt gewählt ist, dass eine Nennstrom-Aufnahme der Last (2) zu einem Ausgangsstrom (IA1) des High-Side-Switch-Ausgangs (A1) führt, der zumindest 50% unterhalb der maximalen Stromtragfähigkeit des High-Side-Switch-Ausganges (A1) liegt.

5. Fahrzeugschaltungsanordnung (1) nach einem der vorhergehenden Ansprüche, wobei die Stromtragfähigkeit des High-Side-Switch-Ausganges (A1) maximal 100 mA beträgt.

6. Fahrzeugschaltungsanordnung (1) nach einem der vorhergehenden Ansprüche, wobei die Fahrzeugschaltungsanordnung (1) die zu versorgende Last (2) umfasst, wobei diese Last (2) einen Lüfter aufweist.

7. Fahrzeugschaltungsanordnung (1) nach einem der vorhergehenden Ansprüche, wobei die Fahrzeugschaltungsanordnung (1) die zu versorgende Last (2) umfasst, wobei diese Last (2) ein Lichtmodul, insbesondere ein LED-Lichtmodul, aufweist.

8. Fahrzeugschaltungsanordnung (1) nach einem der vorhergehenden Ansprüche, wobei der High-Side-Switch (S1) als Teil eines System-Basis-Chips ausgebildet ist.

9. Elektrisches Fahrzeugsystem, umfassend eine Fahrzeugschaltungsanordnung nach einem der vorhergehenden Ansprüche und eine Fahrzeugbatterie zur Ausgabe der Fahrzeugbordspannung, wobei die Fahrzeugbatterie mit dem Fahrzeugbordspannungseingang (E1) der Fahrzeugschaltungsanordnung (1) elektrisch verbunden ist.

10. Fahrzeugscheinwerfer, umfassend eine Fahrzeugschaltungsanordnung (1) nach einem der vorhergehenden Ansprüche.

11. Fahrzeug, umfassend eine Fahrzeugschaltungsanordnung (1) nach einem der Ansprüche 1 bis 8, ein Fahrzeugsystem nach Anspruch 9 und/oder einen Fahrzeugscheinwerfer nach Anspruch 10.
